(19) Europäisches Patentamt

European Patent Office

Office européen des brevets

(11) **EP 4 763 437 A1**

(12) **EUROPEAN PATENT APPLICATION**

(43) Date of publication:
24.06.2026 Bulletin 2026/26

(21) Application number: 25220786.5

(22) Date of filing: 04.12.2025

(51) International Patent Classification (IPC):
***B25J 9/16*** *(2006.01)*

(52) Cooperative Patent Classification (CPC):
**B25J 9/1671;** B25J 9/1605; G05B 2219/32351;
G05B 2219/40099; G05B 2219/40515

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.12.2024 JP 2024224108**

(71) Applicant: **Seiko Epson Corporation
Tokyo 160-8801 (JP)**

(72) Inventor: **TODA, Jun
Suwa-shi, Nagano, 392-8502 (JP)**

(74) Representative: **MERH-IP Matias Erny Reichl
Hoffmann
Patentanwälte PartG mbB
Paul-Heyse-Straße 29
80336 München (DE)**

(54) **METHOD OF CREATING SIMULATION DATA, METHOD OF DISPLAYING PREVIEW IMAGE, AND SIMULATION APPARATUS**

(57) A method of creating simulation data includes (a) operating a virtual robot disposed in a virtual work space which is a virtual three-dimensional work space based on an operation instruction of a user, and displaying, on a display device, a simulator image representing an operation of the virtual robot in the virtual work space, (b) outputting a snapshot representing a two-dimensional image obtained by imaging a state where a virtual three-dimensional object including the virtual robot is disposed in the virtual work space with a virtual camera, and (c) storing, as simulation data, in a memory, an operation program representing a target operation of the virtual robot based on the operation instruction, layout data representing a position and a posture of the object in the virtual work space, attribute data representing an attribute of the object, and the snapshot.

EP 4 763 437 A1

## Description

The present application is based on, and claims priority from JP Application Serial Number 2024-224108, filed December 19, 2024, the disclosure of which is hereby incorporated by reference herein in its entirety.

BACKGROUND

1. Technical Field

The present disclosure relates to a method of creating simulation data, a method of displaying a preview image, and a simulation apparatus.

2. Related Art

JP-A-2021-45797 discloses a technology related to a simulation apparatus that calculates a behavior of a robot.

SUMMARY

There is a demand to store data indicating information on a behavior of a robot calculated by simulation and to use the data on another computer different from the computer on which the simulation is executed to confirm the behavior of the robot in a virtual space, for example. In this case, it is assumed that data indicating the information on the behavior of the robot calculated by the simulation is stored. In the technique described in JP-A-2021-45797, storing of data indicating the information on the behavior of the robot calculated by simulation is not considered. In addition, since processing of constructing the virtual space has a high load, a technology for storing the simulation data in a form in which the user can grasp the content of the simulation before constructing the virtual space is desired.

The present disclosure can be implemented in the following aspects.

According to a first aspect of the present disclosure, there is provided a method of creating simulation data. The method of creating simulation data includes: (a) operating a virtual robot disposed in a virtual work space which is a virtual three-dimensional work space based on an operation instruction of a user, and displaying, on a display device, a simulator image representing an operation of the virtual robot in the virtual work space; (b) outputting a snapshot representing a two-dimensional image obtained by imaging a state where a virtual three-dimensional object including the virtual robot is disposed in the virtual work space with a virtual camera; and (c) storing, as simulation data, in a memory, an operation program representing a target operation of the virtual robot based on the operation instruction, layout data representing a position and a posture of the object in the virtual work space, attribute data representing an attribute of the object, and the snapshot.

According to a second aspect of the present disclosure, there is provided a method of displaying a preview image using simulation data. The simulation data includes (i) an operation program configured with a plurality of commands for causing a robot to perform a target operation, (ii) layout data representing a position and a posture of a three-dimensional object including a virtual robot disposed in a virtual work space which is a virtual three-dimensional work space, (iii) attribute data representing an attribute of the object, and (iv) a snapshot which is a two-dimensional image representing a state of the virtual work space. The method of displaying includes: (a) receiving selection of the simulation data; (b) reading the snapshot included in the selected simulation data from a memory; (c) displaying the snapshot on a display device as the preview image in a mode in which the selected simulation data can be specified; (d) reading the layout data and the attribute data included in the selected simulation data from the memory when an instruction to construct a simulator environment is received; and (e) constructing the simulator environment in which the object is disposed in the virtual work space and displaying a simulator image representing an operation of the virtual robot disposed in the virtual work space on the display device using the read layout data and attribute data.

According to a third aspect of the present disclosure, there is provided a simulation apparatus that executes the processing using simulation data. The simulation data includes (i) an operation program configured with a plurality of commands for causing a robot to perform a target operation, (ii) layout data representing a position and a posture of a three-dimensional object including a virtual robot disposed in a virtual work space which is a virtual three-dimensional work space, (iii) attribute data representing an attribute of the object, and (iv) a snapshot which is a two-dimensional image representing a state of the virtual work space. The simulation apparatus includes: a simulator section that uses the layout data and the attribute data to construct a simulator environment in which the object is disposed in the virtual work space, and operates the virtual robot disposed in the virtual work space in the simulator environment based on an operation instruction of a user and displays a simulator image representing an operation of the virtual robot disposed in the virtual work space on a display device; a snapshot output section that outputs the snapshot, which is the two-dimensional image obtained by imaging a state in which the object including the virtual robot is disposed in the virtual work space by a virtual camera; and a data storage section that stores the simulation data including the operation program representing the target operation of the virtual robot based on the operation instruction, the layout data, the attribute data, and the snapshot in a memory. When a selection of the desired simulation data is received from the user, the simulator section reads the snapshot included in the selected simulation data from the memory, and displays the snapshot as a preview image on the display device in a mode in which the selected simulation data can be identified and when an instruction for constructing the simulator environment is received from the user, the simulator section reads the layout data and the attribute data included in the selected simulation data from the memory and constructs the simulator environment by using the read layout data and attribute data and displays the simulator image on the display device.

## BRIEF DESCRIPTION OF THE DRAWINGS

FIG. 1 is a schematic diagram illustrating an overall configuration of a robot system according to the present embodiment.
FIG. 2 is a block diagram illustrating a functional configuration of an information processing apparatus.
FIG. 3 is a flowchart illustrating processing of selecting a simulation file group.
FIG. 4 is an explanatory diagram illustrating an example of a folder selection screen.
FIG. 5 is an explanatory diagram illustrating an example of a confirmation screen.
FIG. 6 is an explanatory diagram illustrating an example of a simulator screen.
FIG. 7 is a flowchart illustrating store processing of the simulation file group.
FIG. 8 is a flowchart illustrating processing of generating a snapshot of Step S250 illustrated in FIG. 7.
FIG. 9 is a flowchart illustrating processing of generating a snapshot according to the second embodiment.
FIG. 10 is an explanatory diagram illustrating an example of a screen for presenting a Pareto solution.

## DESCRIPTION OF EMBODIMENTS

A. First Embodiment:

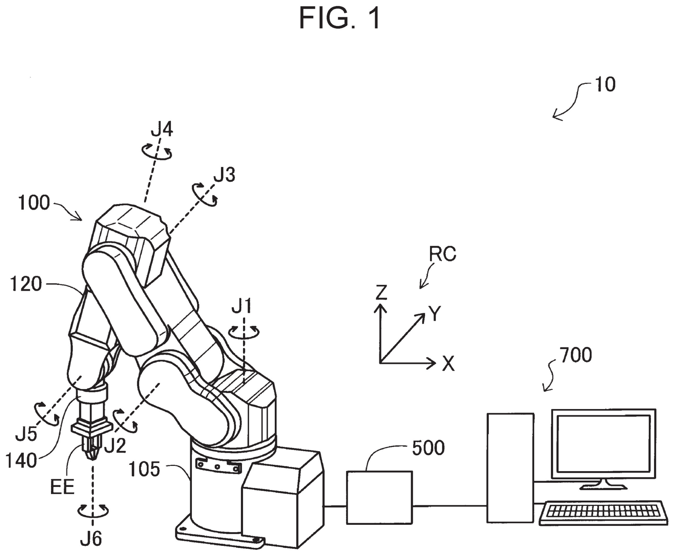

FIG. 1 is a schematic diagram illustrating an overall configuration of a robot system 10 according to the present embodiment. As illustrated in FIG. 1, the robot system 10 includes a robot 100, an end effector EE, a controller 500 that controls the robot 100, and an information processing apparatus 700. The information processing apparatus 700 is, for example, a personal computer. The end effector EE is, for example, a gripper.
In FIG. 1, a robot coordinate system RC is set. The robot coordinate system RC is a three-dimensional orthogonal coordinate system having a predetermined position of the robot 100 as an origin. For example, an arbitrary position of a base 105 is set as the origin. The X axis and the Y axis are axes along a horizontal direction, and the Z axis is an axis along a vertical direction.
The robot 100 is a vertical articulated robot having six joints. The robot 100 is driven by the controller 500. The robot 100 includes the base 105 that supports an arm 120, the arm 120, a force sensor 140, and a drive mechanism that drives each joint. The arm 120 includes six arm elements and joints J1 to J6 that couple the arm elements. The illustration of each drive mechanism that drives the joints J1 to J6 is omitted. The force sensor 140 detects the magnitude of forces parallel to the X axis, the Y axis, and the Z axis acting on the end effector EE in a sensor coordinate system different from the robot coordinate system RC, and the magnitude of torque around each axis. The sensor coordinate system is a three-dimensional orthogonal coordinate system with an arbitrary position of the force sensor 140 as an origin. The force sensor 140 outputs the detection value to the controller 500.
The control point of the robot 100 is set at, for example, a predetermined position of the distal end of the arm 120. The control point is a point that is a reference for controlling the robot 100 in the robot coordinate system RC. The control point may be referred to as a Tool Center Point (TCP). The position of the control point in the robot coordinate system RC can be represented by the position in the X axis direction, the position in the Y axis direction, and the position in the Z axis direction. The posture of the control point in the robot coordinate system RC can be represented by a rotation angle around the X axis, a rotation angle around the Y axis, and a rotation angle around the Z axis. Each drive mechanism corresponding to each of the joints J1 to J6 drives the corresponding joint according to the control of the controller 500, so that the end effector EE is disposed at a position and a posture designated in the robot coordinate system RC.

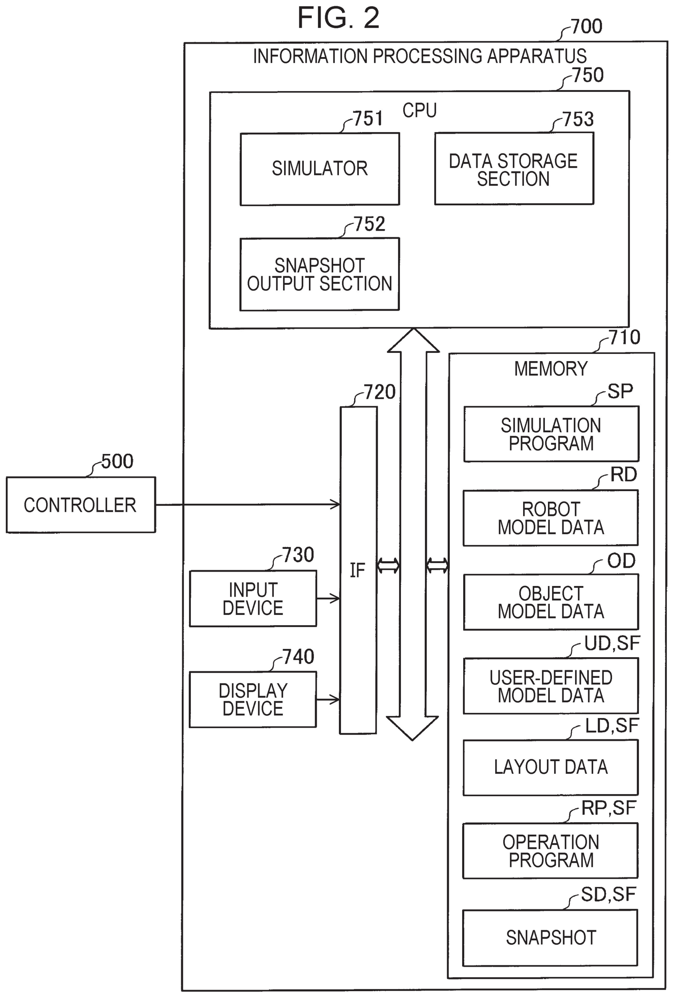

FIG. 2 is a block diagram illustrating a functional configuration of the information processing apparatus 700. The information processing apparatus 700 executes a simulation in a state where a virtual robot corresponding to the robot 100 is disposed in a virtual work space. The virtual robot is also referred to as a "virtual robot". By executing the simulation, for example, the operation of the robot 100 can be instructed, and the disposition of the robot 100 in the work space can be confirmed. The information processing apparatus 700 is also referred to as a "simulation apparatus". Hereinafter, the virtual work space is referred to as a "virtual work space". In the virtual work space, one or more virtual objects corresponding to one or more objects actually disposed around the robot 100 when the robot 100 is actually operated are disposed. The object actually disposed around the robot 100 in the actual work space is, for example, a belt conveyor or a workbench.
The information processing apparatus 700 includes a memory 710, an interface circuit 720, an input device 730 and a display device 740 joined to the interface circuit 720, and a CPU 750 as a processor. The controller 500 is further joined to the interface circuit 720. The information processing apparatus 700 and the controller 500 can communicate with each other. For example, the information processing apparatus 700 supplies an operation command based on an operation program to the controller 500, and the controller 500 can operate the robot 100 based on the given operation command. The input device 730 is, for example, a keyboard or a mouse. The display device 300 is, for example, a liquid crystal display or an organic electro luminescence (EL) display.

The memory 710 stores a simulation program SP, robot model data RD, object model data OD, user-defined model data UD, layout data LD, an operation program RP, and a snapshot SD.

The CPU 750 executes the simulation program SP to realize the functions of a simulator 751, a snapshot output section 752, and a data storage section 753, which will be described later. The simulator 751 is also referred to as a "simulator section".

The robot model data RD includes various robot characteristic data including the configuration and the movable range of the arm 120. Further, the robot model data RD includes three-dimensional computer aided design (CAD) data representing a three-dimensional shape of the robot. When the robot is also handled as one of the objects, the data representing the three-dimensional shape of the robot is included in the "attribute data" representing the attribute of the object. The three-dimensional shape of the robot may be represented by a polygon mesh which is a set of vertices, edges, and surfaces defining the shape of the robot.

The object model data OD includes three-dimensional CAD data representing a three-dimensional shape of an object that can be disposed in the virtual work space. The object model data OD is defined for the object model for which the shape is defined in advance. The object model whose shape is defined in advance is, for example, a sphere, a rectangular parallelepiped, or a cylinder.

The user-defined model data UD is an object that can be disposed in the virtual work space, and includes three-dimensional CAD data representing a three-dimensional shape of an object independently defined by the user. The data representing the three-dimensional shape of the object is included in "attribute data" representing the attribute of the object. The three-dimensional shape of the object may be represented by a polygon mesh which is a set of vertices, edges, and surfaces defining the shape of the object.

The layout data LD includes data of the positions and postures of the robot and one or more objects disposed in the virtual work space. For example, the positions of the robot and the one or more objects are represented by the coordinate values in the coordinate system set in the virtual work space. For example, the posture of each of the robot and the one or more objects is represented by a quaternion, Euler angles, or the like. The layout data LD further includes data of the type of the robot, the type, size, and color of each of the one or more objects disposed in the work space of the robot. The size and color of the robot are uniquely determined according to the type of the robot. The layout data LD is created or edited in the simulation described later. The type of the robot, and the type, size, and color of each of the one or more objects are also referred to as "object attributes". In the present embodiment, the layout data LD includes a part of "attribute data" representing an attribute of an object.

The operation program RP is configured with a plurality of operation commands in order to cause the robot 100 to perform a target operation. The operation program RP is created or edited in the simulation described later.

The snapshot SD is a two-dimensional image representing a state in which the robot and one or more objects are disposed in the virtual work space. The snapshot SD represents a state in which the robot and one or more objects are disposed at a certain moment. The snapshot SD is created in a simulation described later.

In the present embodiment, the layout data LD, the operation program RP, and the snapshot SD may be collectively handled. The layout data LD, the operation program RP, and the snapshot SD are collectively referred to as a simulation file group SF. In the present embodiment, the layout data LD, the operation program RP, and the snapshot SD that correspond to each other are stored in the memory 710 in a state of being stored in one folder. The simulation file group SF is also referred to as "simulation data".

The CPU 750 functions as the simulator 751, the snapshot output section 752 that outputs the snapshot SD, and the data storage section 753 that stores the simulation file group SF in the memory 710 by executing the simulation program SP.

The simulator 751 constructs a simulator environment in which an object is disposed in a virtual work space by using the layout data LD, the robot model data RD, the object model data OD, and the user-defined model data UD. The simulator 751 operates the robot disposed in the virtual work space in the simulator environment, and displays a simulator image representing the operation of the robot in the virtual work space on the display device 740.

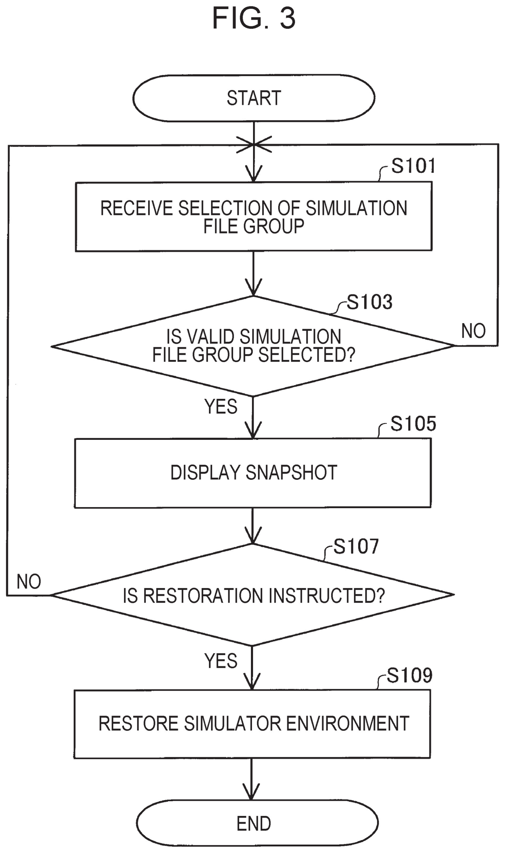

FIG. 3 is a flowchart illustrating processing of selecting the simulation file group according to the present embodiment. When the user starts the simulation program SP, the processing illustrated in FIG. 3 is started. In the present embodiment, an example using the simulation file group SF created by executing the previous simulation will be described.

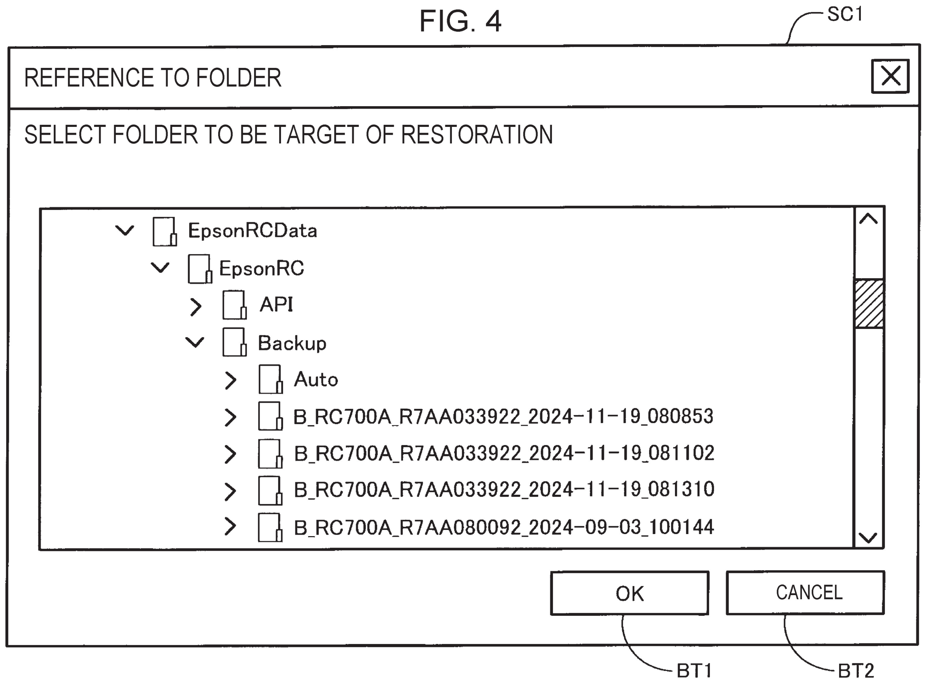

In Step S101, the selection of the simulation file group SF can be received. FIG. 4 is an explanatory diagram illustrating an example of the folder selection screen SC1. As described above, the simulation file group is stored in the memory 710 in a state where the simulation file group is stored in one folder. When the simulation program SP is started, for example, the selection screen SC1 as illustrated in FIG. 4 is displayed on the display device 740. In the selection screen SC1, a list of folders for storing the simulation file group SF already created is displayed. The user selects a desired folder on the selection screen SC1 using the input device 730. When an "OK" button BT1 is pressed, the selection of the simulation file group SF can be received. When a "cancel" button BT2 is pressed, the selection screen SC1 is closed. The processing in Step S101 is executed by the CPU 750 that functions as the simulator 751.

As illustrated in FIG. 3, in Step S103, it is determined whether or not the valid simulation file group SF is selected. The selection of the valid simulation file group SF means that the user has selected a folder in which the simulation file group SF including the layout data LD, the operation program RP, and the snapshot SD is stored. When the valid simulation file group SF is selected (Step S103; YES), the processing in Step S105 is executed. When the valid simulation file group SF is not selected (Step S103; NO), for example, after it is notified that the valid simulation file group SF is not selected on a display screen (not illustrated), the processing in Step S101 is executed again. The processing in Step S103 is executed by the CPU 750 that functions as the simulator 751.

In Step S105, a confirmation screen SC2 including the snapshot SD included in the selected simulation file group SF is displayed on the display device 740.

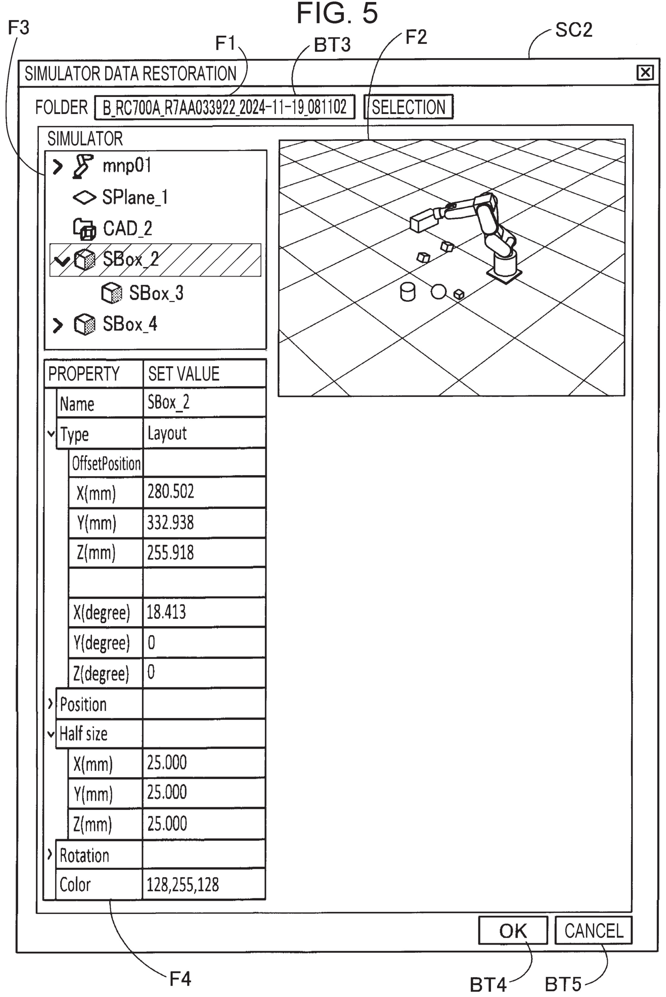

FIG. 5 is an explanatory diagram illustrating an example of the confirmation screen SC2. The confirmation screen SC2 includes a display area F1 representing the name of the folder in which the selected simulation file group is stored, a display area F2 representing the snapshot SD, a display area F3 representing the layout of the robot and one or more objects disposed in the virtual work space, and a display area F4 representing the attribute of the object. The snapshot SD is displayed as the preview image on the confirmation screen SC2. In the display area F3, the two or more hierarchically arranged objects are displayed in a mode in which the hierarchization can be visually recognized. The two or more objects being hierarchically arranged means that two or more objects are grouped and the rank of the object is defined. For example, "SBox_2" and "SBox_3" are grouped, and "SBox_2" is set to a higher rank than "SBox_3". In other words, for example, "SBox_2" is an object of the upper hierarchy, and "SBox_3" is an object of the lower hierarchy. For example, when the disposition position in the display area F3 of the object of the upper hierarchy among two or more hierarchically arranged objects is changed by the operation of the user, the object of the lower hierarchy is also moved together with the object of the upper hierarchy.

In order to display the confirmation screen SC2, the snapshot SD included in the selected simulation file group SF is first read from the memory 710. Furthermore, the layout data LD included in the selected simulation file group is read from the memory 710. The confirmation screen SC2 is generated based on the read snapshot SD and layout data LD. The processing in Step S105 is executed by the CPU 750 that functions as the simulator 751.

As illustrated in FIG. 3, in Step S107, it is determined whether or not the restoration is instructed. When a "cancel" button BT5 is pressed on the confirmation screen SC2, it is determined that the restoration is canceled. When the restoration is canceled (Step S107; NO), the confirmation screen SC2 is closed. Thereafter, the processing in Step S101 is executed again. When the "OK" button BT4 is pressed on the confirmation screen SC2, it is determined that the restoration is instructed. When the restoration is instructed (Step S107; YES), the processing in Step S109 is executed. The instruction of restoration is also referred to as an "instruction of constructing a simulator environment". When the "selection" button BT3 is pressed on the confirmation screen SC2, the confirmation screen SC2 is not closed, and the selection screen SC1 is displayed again. In this case, the user can reselect the folder on the selection screen SC1. The processing in Step S107 is executed by the CPU 750 that functions as the simulator 751.

In Step S109, the restoration is executed based on the selected simulation file group SF. First, the layout data LD, the robot model data RD, and the object model data OD included in the selected simulation file group SF are read from the memory 710. When the user-defined model data UD is included, the user-defined model data UD is also read from the memory 710. A three-dimensional object of the robot corresponding to an appearance in the virtual work space represented as the three-dimensional space is generated based on the layout data LD and the robot model data RD. A three-dimensional object of an object corresponding to the appearance in the virtual three-dimensional space in the work space is generated based on the layout data LD and the object model data OD. When the object to be disposed is the object independently defined by the user, the user-defined model data UD is used instead of the object model data OD for generating the three-dimensional object. Each of the generated three-dimensional objects is disposed in the virtual work space based on the layout data LD. In this way, the simulator environment is constructed.

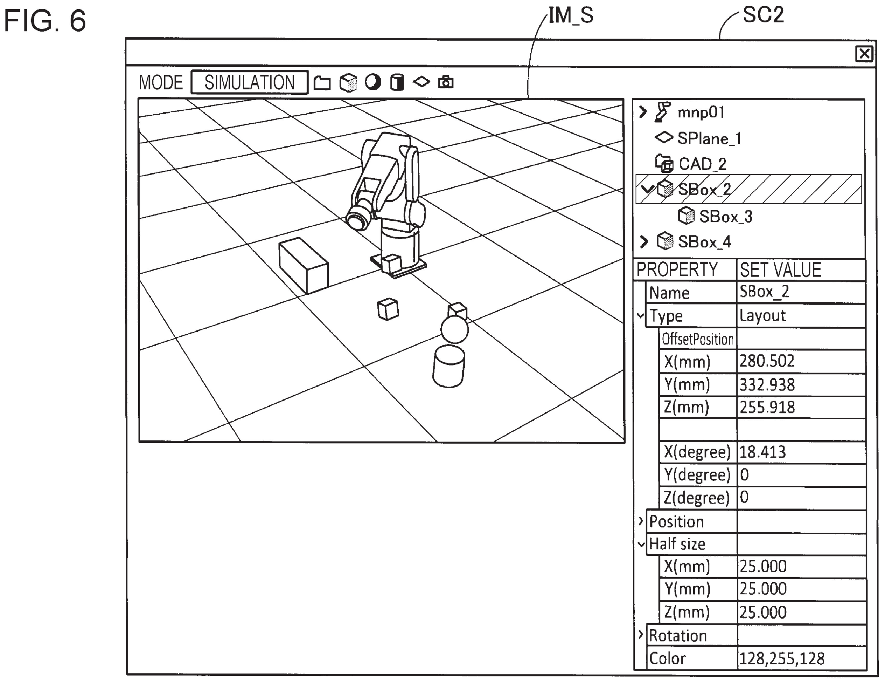

FIG. 6 is an explanatory diagram illustrating an example of the simulator screen SC3. The simulator screen SC3 is displayed on the display device 740 when the simulator environment is constructed. Here, an image IM_S representing the virtual work space when the virtual work space is viewed in a predetermined line of sight direction is displayed on the display device 740. In the virtual work space, the robot and one or more objects are disposed at the position and posture based on the layout data LD. In the simulator environment, the positions and postures of the robot and the object are changed in response to the operation instruction of the user. In the simulator environment, the robot can be operated according to the operation program RP. Further, in the simulator environment, the operation of the robot can be changed in response to the operation instruction of the user, and the operation program RP can be updated to reflect the changed operation.

As described above, in the present embodiment, the simulation environment is not constructed at the stage where the user selects the folder storing the simulation file group SF, and the confirmation screen SC2 including the snapshot SD is displayed (refer to FIG. 5). In the confirmation screen SC2, when the restoration is instructed, the robot model data RD, the object model data OD, and the user-defined model data UD are read from the memory 710, and the processing of generating a three-dimensional object is executed in order to construct the simulator environment. In general, in the simulation, a state in which the virtual three-dimensional object including the virtual robot is disposed in a virtual work space is determined, and the attribute information such as a shape is given to each object. Therefore, it is necessary to read the shape data of each object and to perform processing such as reproducing the shape of each object. In addition, the larger the number of objects disposed in the virtual work space, the higher the load of these processes.

In the present embodiment, at the stage where the user selects the folder in which the simulation file group SF is stored, the robot model data RD, the object model data OD, and the like are not read from the memory 710, and the snapshot SD and the layout data LD are read from the memory 710. The snapshot SD is displayed as a preview image. Therefore, the user can confirm the snapshot SD as the preview image representing the contents of the selected folder before executing the processing of reading the shape data of each object and the like for constructing the simulator environment, and the processing of reproducing the shape of each object. Therefore, the user can confirm whether the data stored in the selected folder is the data related to the desired simulation environment. Therefore, the occurrence of an erroneous operation of executing the processing of constructing the simulation environment by using erroneous simulation data can be suppressed.

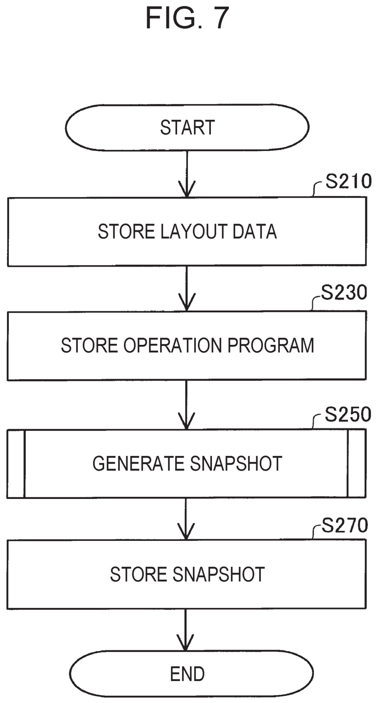

Next, the processing of storing the simulation file group SF will be described. FIG. 7 is a flowchart illustrating store processing of the simulation file group SF. The processing illustrated in FIG. 7 is executed when the simulation environment is constructed and the user instructs the storing of the simulation file group SF.

In Step S210, the layout data LD reflecting the current simulation environment is stored in the memory 710. In Step S230, the operation program RP reflecting the current simulation environment is stored in the memory 710. In Step S250, the snapshot SD is generated. Details of the processing of generating the snapshot SD will be described later. In Step S270, the snapshot SD is stored in the memory 710. The layout data LD, the operation program RP, and the snapshot SD are stored in the memory 710 in a state of being stored in one folder. Thereafter, the processing illustrated in FIG. 7 is ended. Steps S210, S230, and S270 are executed by the processor that functions as the data storage section 753. Step S250 is executed by the CPU 750 that functions as the snapshot output section 752.

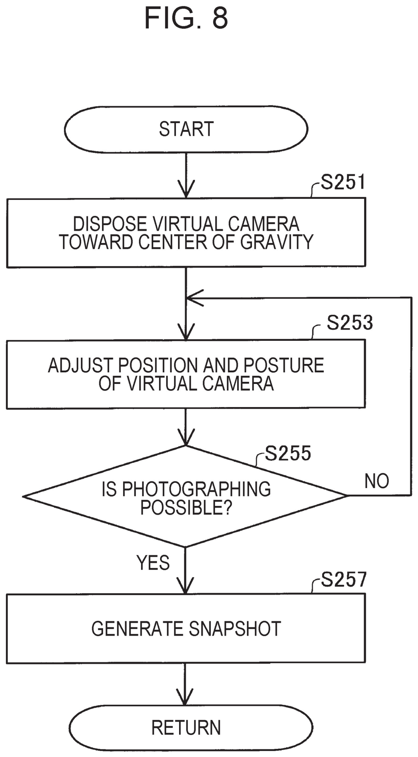

FIG. 8 is a flowchart illustrating processing of generating the snapshot SD of Step S250 illustrated in FIG. 7.

In Step S251, the lens of the virtual camera is disposed in the virtual work space at the position and posture at which the lens of the virtual camera faces a center of gravity. In the present embodiment, the position representing the center between the plurality of objects disposed in the virtual work space is referred to as the center of gravity. Here, the robot is also handled as one of the objects. For example, when the plurality of objects are viewed from above in the virtual work space, the centroid of the polygon drawn when the centers of the objects are connected by a straight line is obtained as the center of gravity. When the number of objects is only two, the polygon cannot be drawn, and thus the midpoint of the line segment connecting the two objects is obtained as the center of gravity. The position of the virtual camera is represented by a coordinate value in a coordinate system set in the virtual work space. The posture of the virtual camera is represented by a quaternion, Euler angles, or the like. For example, the virtual camera is directed to the center of gravity determined from a predetermined direction. By directing the virtual camera to the center of gravity of the object set, the possibility that the virtual camera includes as many objects as possible in the photographing range is increased. Here, it is not always necessary to dispose the virtual camera in the virtual work space, and it is sufficient that the position for disposing the virtual camera is determined. The same applies to the following steps.

As a method of calculating the center of gravity, another calculation method may be adopted. For example, an average value obtained by dividing the total sum of the coordinate positions of all the objects disposed in the virtual work space by the number of the objects may be used as the center of gravity. Specifically, the center of gravity can be calculated by the following Expression (M1). In the following Expression (M1), n represents the number of objects. $P_i$ represents the coordinate value of the object in the virtual space. For example, when the position in the virtual work space is represented by the orthogonal coordinate system, $P_i$ represents the coordinates (x, y, z) of the i-th object. In the Expression (M1), the total sum of the x coordinate, the y coordinate, and the z coordinate is obtained as the total sum of $P_i$.

[Math. 1]

$$G = \frac{\sum_{i=1}^{n} P_i}{n}$$

$$\cdots (\mathrm{M}1)$$

In Step S253, the position and the posture of the virtual camera are adjusted.

As follows, the position and the posture of the virtual camera are adjusted. The virtual camera needs to be disposed at a position where at least the robot is included in the photographing range of the virtual camera. For example, the position of the virtual camera may be changed by adding a constant value to each of the X coordinate value, the Y coordinate value, and the Z coordinate value of the virtual camera to set the changed coordinate as a new position of the virtual camera in the coordinate system set in the virtual work space. Alternatively, the position and the posture of the virtual camera may be changed so that the distance between the virtual camera and any object is decreased by a predetermined distance. As any object, the robot may be selected, the object closest to the virtual camera may be selected, or the object farthest from the virtual camera may be selected.

In Step S255, it is determined whether or not photographing is possible. For example, it is determined that the photographing can be performed when all of the following conditions are satisfied.

(1) At least the robot is included in the photographing range of the virtual camera.
(2) The straight-line distance between the virtual camera and the selected object is within a predetermined range.

Regarding the above (1), for example, when an angle formed by an optical axis of the virtual camera and a straight line connecting a predetermined portion of the virtual camera and the robot is a half angle of view or less of the virtual camera, it is possible to determine that the robot is included in a photographing range of the virtual camera. The half angle of view is half of the angle of view. Whether an object other than the robot is included in the photographing range of the virtual camera by the same method can be determined.

Regarding the above (2), the straight-line distance between the virtual camera and the selected object can be calculated based on the coordinate value of the virtual camera and the coordinate value of the selected object in the coordinate system set in the virtual work space. The selected object may be a robot. The selected object may be an object closest to the virtual camera. Exceeding the upper limit value of the predetermined range of the straight-line distance indicates that the virtual camera is too far away from the photographing target. The fact that the straight-line distance is less than the lower limit value of the predetermined range indicates that the virtual camera is too close to the photographing target.

When it is determined that the photographing is possible (Step S255; YES), Step S257 is executed. When it is determined that the photographing is not possible (Step S255; NO), the processing in Step S253 is executed again.

In Step S257, the snapshot SD is generated.

Specifically, the two-dimensional image obtained by the virtual camera imaging the state in which the object is disposed in the virtual work space is generated as the snapshot SD at the position and the posture of the virtual camera when it is determined that the photographing is possible. The above is the processing for generating the snapshot SD.

B. Second Embodiment:

In the second embodiment, optimization processing is used as a method of determining the position and the posture of the virtual camera at the time of generating the snapshot SD. Hereinafter, a description will be made of a configuration different from that of the first embodiment, and the description of the same configuration as that of the first embodiment will be omitted. In the present embodiment, it is assumed that a plurality of objects including a robot are disposed in a virtual work space. As a method of the optimization process, an algorithm for multi-objective optimization such as Non-dominated Sorting Genetic Algorithms II (NSGA-II) and Strength Pareto Evolutionary Algorithm (SPEA2) is used.

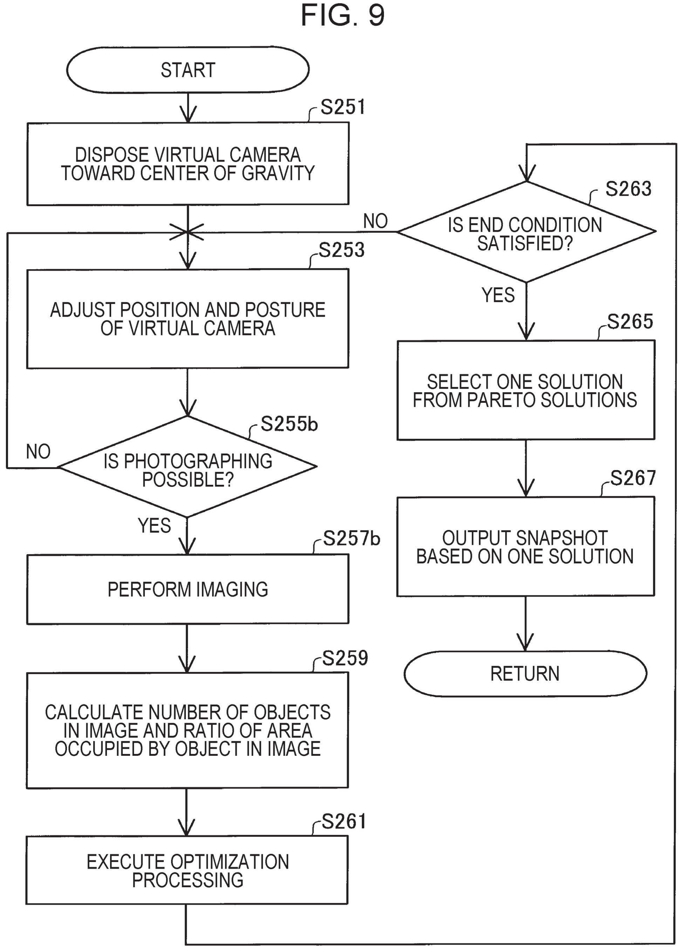

FIG. 9 is a flowchart illustrating processing of generating a snapshot according to the present embodiment.

Steps S251 and S253 are the same as in the first embodiment. In Step S255b, it is determined whether or not photographing is possible. For example, it is determined that photographing is possible when any object is included in the photographing range.

When it is determined that the photographing is not possible (Step S255b; NO), the processing in Step S253 is executed again. When it is determined that the photographing is possible (Step S255b; YES), Step S257b is executed.

In Step S257b, a state in which the object is disposed in the virtual work space is imaged by the virtual camera. Specifically, a two-dimensional image obtained by imaging the state in which the object is disposed in the virtual work space by the virtual camera is generated at the position and posture of the virtual camera when it is determined that the photographing is possible.

In Step S259, the number of objects included in the two-dimensional image obtained in Step S257b and the ratio of the area occupied by the object in the image to the entire image are calculated. The object in the image can be detected by using a known object detection algorithm. In the present embodiment, the number of objects included in the two-dimensional image (hereinafter, evaluation value A) and the ratio of the area occupied by the object in the image to the entire image (hereinafter, evaluation value B) are values to be optimized. The calculated evaluation value A and the evaluation value B are stored in the memory 710 in association with information for specifying the two-dimensional image.

In Step S261, the optimization processing is executed with the evaluation value A and the evaluation value B as initial values. Here, NSGA-II is used as the algorithm of the optimization process. As the constraint conditions, for example, it is set that the evaluation value A is not equal to or more than a predetermined first value, and the evaluation value B is not equal to or more than a predetermined second value. The fact that the evaluation value A is the predetermined first value or more indicates that the number of objects in the image is too large. When the number of objects in the image is too large, it is assumed that the virtual camera is too far away from the object. The fact that the evaluation value B is the predetermined second value or more indicates that the area occupied by the object in the image is too large. When the area occupied by the object in the image is too large, it is assumed that the virtual camera is too close to the object.

In Step S263, it is determined whether or not the end condition is satisfied. For example, when the processing in Step S261 is executed a predetermined number of times, it is determined that the end condition is satisfied. When it is determined that the end condition is not satisfied (Step S263; NO), Step S253 is executed again. When Step S253 is executed again, for example, the position and the posture of the virtual camera are adjusted by moving the virtual camera in a predetermined direction by a predetermined distance. In addition, when an algorithm for performing optimization processing such as NSGA-II is used, the adjustment of the position and the posture of the virtual camera may be determined by using the algorithm for performing the optimization process.

When it is determined that the end condition is satisfied in Step S263 (Step S263; YES), Step S265 is executed.

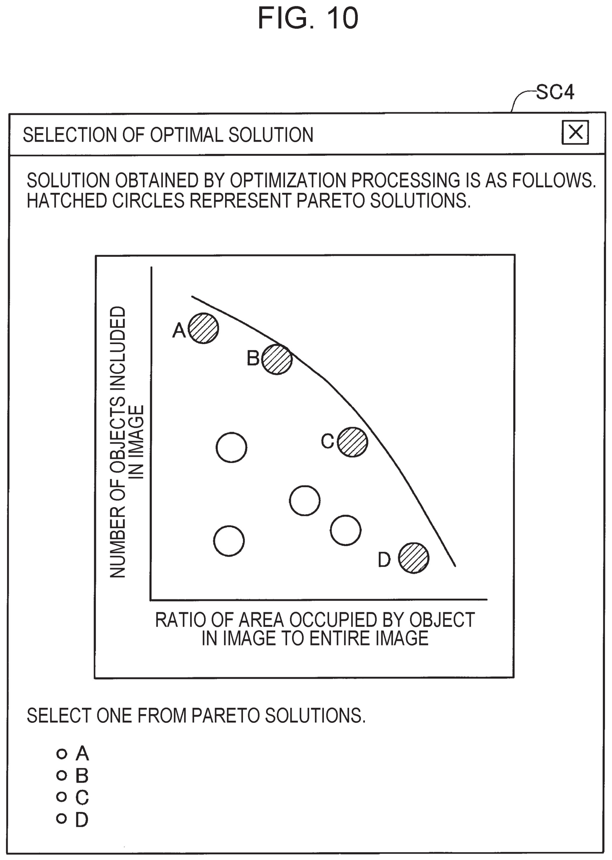

FIG. 10 is an explanatory diagram illustrating an example of a result screen displayed for presenting a Pareto solution. As illustrated in FIG. 9, in Step S265, one solution is selected from the set of Pareto solutions obtained by the optimization process. For example, as illustrated in FIG. 10, the result screen SC4 including the image representing the Pareto solution may be displayed on the display device 740, and the user may be allowed to select the one solution. In the result screen SC4, a graph in which one of the evaluation value A and the evaluation value B is a horizontal axis and the other is a vertical axis, and in which all the solutions obtained by the Pareto solution and the optimization processing are plotted is illustrated. In the example illustrated in FIG. 10, plotted points of the solutions are hatched to display the graph in a manner that allows the user to recognize that they are Pareto solutions. On the result screen SC4 illustrated in FIG. 10, the user can select any Pareto solution by using the input device 730.

In Step S267, the two-dimensional image associated with the evaluation value A and the evaluation value B represented by the selected one solution is output as a snapshot SD. The above is the processing for generating the snapshot. In the present embodiment, the position and the posture of the virtual camera can be easily determined by using the optimization process.

C. Other Embodiments

(C1) In the first embodiment, it is determined that photographing is possible when the following conditions are all satisfied (refer to Step S255 in FIG. 8).

    (1) At least the robot is included in the photographing range of the virtual camera.
    (2) The straight-line distance between the virtual camera and the selected object is within a predetermined range.

The conditions for determining that the photographing is possible are not limited to the above (1) and (2). For example, the following conditions can be adopted.
(3) The number of objects included in the photographing range is L or more (L is an integer) and M or less (M is an integer larger than L).
When the plurality of objects are disposed in the virtual work space, the snapshot SD in which the layout of the objects in the virtual work space is reproduced as much as possible can be obtained by including as many objects as possible in the photographing range of the virtual camera. In addition, it may be determined that photographing is possible when any one of the above-described conditions (1) to (3) is satisfied.
(C2) The information processing apparatus 700 may determine whether or not the two-dimensional image can be adopted as the snapshot SD after generating the two-dimensional image obtained by imaging a state in which the virtual camera images the virtual work space in which the object is disposed. For example, when at least the robot is included in the photographing range of the virtual camera, it is determined that the photographing is possible. A two-dimensional image obtained by imaging a state in which an object is disposed in the virtual work space by the virtual camera is generated at a position and a posture of the virtual camera when it is determined that the photographing is possible. Thereafter, it is determined whether or not the generated two-dimensional image can be adopted as the snapshot SD. For example, it may be determined that the generated two-dimensional image can be adopted as the snapshot SD when the ratio of the area occupied by the object in the entire image in the two-dimensional image is within a predetermined range.
(C3) In the first embodiment, an example is described in which, when the virtual camera is first disposed, the virtual camera is disposed in the virtual work space at the position and posture in which the lens of the virtual camera faces the center of gravity, which is the position of the center between the plurality of objects disposed in the virtual work space (refer to Step S251 in FIG. 8). Alternatively, when the virtual camera is first disposed, the position of the virtual camera may be determined such that the selected object enters the photographing range of the virtual camera. Specifically, one object is selected from among the plurality of objects disposed in the virtual work space. The virtual camera is a position where the selected object can be photographed from a predetermined direction with respect to the selected object, and is disposed at a position separated from the selected object by a predetermined distance. The selected object may be a robot or may be an object designated by the user.

(C4) In the first embodiment, an example is described in which the position of the virtual camera is changed by adding a constant value to each of the X coordinate value, the Y coordinate value, and the Z coordinate value of the virtual camera. Alternatively, the information processing apparatus 700 may change the position and the posture of the virtual camera according to the instruction of the user. For example, the virtual camera is displayed on the simulator screen as illustrated in FIG. 6. The information processing apparatus 700 may change the position and the posture of the virtual camera on the simulator screen in accordance with the operation instruction from the user via the input device 730.

(C5) In the second embodiment, the example in which a multi-objective optimization algorithm is used as the optimization processing method is described. Alternatively, a single-objective optimization algorithm may be used as the method of the optimization processing. For example, the evaluation value A, which is the number of objects included in the two-dimensional image that is a candidate for the snapshot SD, and the evaluation value B, which is the ratio of the area occupied by the object in the image to the entire image, are optimized. When the single-objective optimization algorithm is used, the allowable range of one evaluation value can be used as a constraint condition, and the other evaluation value can be optimized. As the single-objective optimization algorithm, random search, grid search, covariance matrix adaptation evolution strategy (CMA-ES), particle swarm optimization (PSO), or the like can be used.

(C6) In the second embodiment, the example is described in which the value to be optimized is the number of objects included in the two-dimensional image obtained in Step S257b and the ratio of the area occupied by the object in the image to the entire image. Alternatively, a value obtained by multiplying the number of objects of a pre-designated type included in the two-dimensional image obtained in Step S257b by the priority set for the object may be a value optimized. In this case, the single-objective optimization algorithm can be used. Before executing the optimization processing, the user needs to designate the type of the object and set the priority of the object.

(C7) In the second embodiment, the example is described in which the information processing apparatus 700 displays the result screen SC4 (refer to FIG. 10) representing the Pareto solution and receives the selection of the one solution from the user. Alternatively, the information processing apparatus 700 may randomly select one solution from the Pareto solutions. Further, the setting in which the user selects the solution according to the designation of the user and the setting in which the solution is randomly selected by the information processing apparatus 700 may be switched.

(C8) In the first embodiment, the example in which the robot system 10 includes the controller 500 is described (refer to FIG. 1), but the robot system 10 may not include the controller 500. In this case, the information processing apparatus 700 may function as a controller of the robot system 10. Further, the present disclosure may be realized by the information processing apparatus 700 alone.

The present disclosure is not limited to the above-described embodiments, and can be realized in various configurations within the scope not departing from the concept of the present disclosure. For example, the technical features in the embodiments corresponding to technical features in respective aspects described in SUMMARY of the present disclosure can be replaced or combined as appropriate in order to eliminate some or all of the above-described problems or to achieve some or all of the above-described effects. In addition, unless the technical features are described as essential in the present specification, the technical features can be deleted as appropriate.

D. Other Aspects:

(1) According to a first aspect of the present disclosure, there is provided a method of creating simulation data. The method of creating simulation data includes: (a) operating a virtual robot disposed in a virtual work space which is a virtual three-dimensional work space based on an operation instruction of a user, and displaying, on a display device, a simulator image representing an operation of the virtual robot in the virtual work space; (b) outputting a snapshot representing a two-dimensional image obtained by imaging a state where a virtual three-dimensional object including the virtual robot is disposed in the virtual work space with a virtual camera; and (c) storing, as simulation data, in a memory, an operation program representing a target operation of the virtual robot based on the operation instruction, layout data representing a position and a posture of the object in the virtual work space, attribute data representing an attribute of the object, and the snapshot. For example, the simulation may be executed by using the stored simulation data on another computer different from the computer on which the simulation is executed. In order to construct the simulation environment, it is necessary to read the shape data of each object and to process the reproduction of the shape of each object. The larger the number of objects disposed in the virtual work space, the higher the load of this processing. According to the above aspect, the simulation data includes the snapshot that is a two-dimensional image obtained by imaging the virtual robot disposed in the virtual work space with the virtual camera. Therefore, the snapshot as the preview image can be presented to the user before executing the processing of reading the shape data of each object and the processing of reproducing the shape of each object. As a result, whether the content of the selected folder is the desired simulation data can be confirmed. Therefore, the occurrence of an erroneous operation of executing the processing of constructing the simulation environment by using erroneous simulation data can be suppressed.

(2) In the method of creating simulation data of the above aspect, in the (b), the virtual camera may be disposed at a position where at least the virtual robot is included in a photographing range of the virtual camera.

(3) In the method of creating simulation data of the above aspect, the (b) may include (b1) changing the position and a posture of the virtual camera so that the number of the objects equal to or more than a predetermined threshold value is included in the photographing range when a plurality of the objects are disposed in the virtual work space, (b2) repeating the (b1) until a repeat end condition is satisfied, and (b3) outputting the two-dimensional image obtained by imaging the state where the object is disposed in the virtual work space by the virtual camera at the position and the posture of the virtual camera when the end condition is satisfied, as the snapshot. According to the above aspect, when the number of objects disposed in the virtual work space is large, it is difficult to include all the objects in the photographing range of the virtual camera. However, by including as many objects as possible in the photographing range of the virtual camera, a snapshot that reproduces the layout of the objects in the virtual work space as much as possible can be obtained.

(4) In the method of creating simulation data of the above aspect, the (b) may further include (b4) executed before the (b1) and disposing the virtual camera at a position and a posture facing a center of gravity of a set of the objects obtained by using the layout data when the plurality of objects are disposed in the virtual work space. According to the above aspect, by directing the virtual camera to the center of gravity of the set of objects, the possibility that the virtual camera includes as many objects as possible in the photographing range of the virtual camera is increased.

(5) In the method of creating simulation data of the above aspect, in the (b1), when the plurality of objects are disposed in the virtual work space, and a straight-line distance between the virtual camera and one of the plurality of objects is equal to or more than a predetermined threshold value, the position and the posture of the virtual camera may be changed such that the straight-line distance is decreased by a predetermined distance.

(6) In the method of creating simulation data of the above aspect, in the (b1), when the plurality of objects are disposed in the virtual work space, a position and a posture of the virtual camera are determined by using optimization processing, and in the optimization processing, the number of the plurality of objects included in the photographing range of the virtual camera and a total sum of areas occupied by the objects in the photographing range of the virtual camera may be optimized. According to the above aspect, the position and the posture of the virtual camera can be easily determined.

(7) In the method of creating simulation data of the above aspect, a shape of the object may be represented by a polygon mesh, and the attribute data representing the attribute of the object may include information defining the polygon mesh.

(8) In the method of creating simulation data of the above aspect, when an instruction to store the simulation data is received, the (b) and the (c) may be executed.

(9) According to a second aspect of the present disclosure, there is provided a method of displaying a preview image using simulation data. The simulation data includes (i) an operation program configured with a plurality of commands for causing a robot to perform a target operation, (ii) layout data representing a position and a posture of a three-dimensional object including a virtual robot disposed in a virtual work space which is a virtual three-dimensional work space, (iii) attribute data representing an attribute of the object, and (iv) a snapshot which is a two-dimensional image representing a state of the virtual work space. The method of displaying the preview image includes: (a) receiving selection of the simulation data; (b) reading the snapshot included in the selected simulation data from a memory; (c) displaying the snapshot on a display device as the preview image in a mode in which the selected simulation data can be specified; (d) reading the layout data and the attribute data included in the selected simulation data from the memory when an instruction to construct a simulator environment is received; and (e) constructing the simulator environment in which the object is disposed in the virtual work space and displaying a simulator image representing an operation of the virtual robot disposed in the virtual work space on the display device using the read layout data and attribute data.

(10) According to a third aspect of the present disclosure, there is provided a simulation apparatus that executes the processing using simulation data. The simulation data includes (i) an operation program configured with a plurality of commands for causing a robot to perform a target operation, (ii) layout data representing a position and a posture of a three-dimensional object including a virtual robot disposed in a virtual work space which is a virtual three-dimensional work space, (iii) attribute data representing an attribute of the object, and (iv) a snapshot which is a two-dimensional image representing a state of the virtual work space. The simulation apparatus includes: a simulator section that uses the layout data and the attribute data to construct a simulator environment in which the object is disposed in the virtual work space, and operates the virtual robot disposed in the virtual work space in the simulator environment based on an operation instruction of a user and displays a simulator image representing an operation of the virtual robot disposed in the virtual work space on a display device; a snapshot output section that outputs the snapshot, which is the two-dimensional image obtained by imaging a state in which the object including the virtual robot is disposed in the virtual work space by a virtual camera; and a data storage section that stores the simulation data including the operation program representing the target operation of the virtual robot based on the operation instruction, the layout data, the attribute data, and the snapshot in a memory. When a selection of the desired simulation data is received from the user, the simulator section reads the snapshot included in the selected simulation data from the memory, and displays the snapshot as a preview image on the display device in a mode in which the selected simulation data can be identified and when an instruction for constructing the simulator environment is received from the user, the simulator section reads the layout data and the attribute data included in the selected simulation data from the memory and constructs the simulator environment by using the read layout data and attribute data and displays the simulator image on the display device.

**Claims**

1.  A method of creating simulation data, the method comprising:

    (a) operating a virtual robot disposed in a virtual work space which is a virtual three-dimensional work space based on an operation instruction of a user, and displaying, on a display device, a simulator image representing an operation of the virtual robot in the virtual work space;
    (b) outputting a snapshot representing a two-dimensional image obtained by imaging a state where a virtual three-dimensional object including the virtual robot is disposed in the virtual work space with a virtual camera; and

    (c) storing, as simulation data, in a memory, an operation program representing a target operation of the virtual robot based on the operation instruction, layout data representing a position and a posture of the object in the virtual work space, attribute data representing an attribute of the object, and the snapshot.

2.  The method of creating simulation data according to claim 1, wherein
    in the (b), the virtual camera is disposed at a position where at least the virtual robot is included in a photographing range of the virtual camera.

3.  The method of creating simulation data according to claim 2, wherein
    the (b) includes

    (b1) changing the position and a posture of the virtual camera so that the number of the objects equal to or more than a predetermined threshold value is included in the photographing range when a plurality of the objects are disposed in the virtual work space,
    (b2) repeating the (b1) until a repeat end condition is satisfied, and
    (b3) outputting the two-dimensional image obtained by imaging the state where the object is disposed in the virtual work space by the virtual camera at the position and the posture of the virtual camera when the end condition is satisfied, as the snapshot.

4.  The method of creating simulation data according to claim 3, wherein
    the (b) further includes
    (b4) executed before the (b1) and disposing the virtual camera at a position and a posture facing a center of gravity of a set of the objects obtained by using the layout data when the plurality of objects are disposed in the virtual work space.

5.  The method of creating simulation data according to claim 4, wherein
    in the (b1), when the plurality of objects are disposed in the virtual work space, and a straight-line distance between the virtual camera and one of the plurality of objects is equal to or more than a predetermined threshold value, the position and the posture of the virtual camera are changed such that the straight-line distance is decreased by a predetermined distance.

6.  The method of creating simulation data according to claim 4, wherein

    in the (b1), when the plurality of objects are disposed in the virtual work space, a position and a posture of the virtual camera are determined by using optimization processing, and in the optimization processing, the number of the plurality of objects included in the photographing range of the virtual camera and a total sum of areas occupied by the objects in the photographing range of the virtual camera are optimized.

7. The method of creating simulation data according to claim 1, wherein

   a shape of the object is represented by a polygon mesh, and
   the attribute data representing the attribute of the object includes information defining the polygon mesh.

8. The method of creating simulation data according to claim 7, wherein
   when an instruction to store the simulation data is received, the (b) and the (c) are executed.

9. A method of displaying a preview image using simulation data, the simulation data including (i) an operation program configured with a plurality of commands for causing a robot to perform a target operation, (ii) layout data representing a position and a posture of a three-dimensional object including a virtual robot disposed in a virtual work space which is a virtual three-dimensional work space, (iii) attribute data representing an attribute of the object, and (iv) a snapshot which is a two-dimensional image representing a state of the virtual work space, the method of displaying comprising:

   (a) receiving selection of the simulation data;
   (b) reading the snapshot included in the selected simulation data from a memory;
   (c) displaying the snapshot on a display device as the preview image in a mode in which the selected simulation data can be specified;
   (d) reading the layout data and the attribute data included in the selected simulation data from the memory when an instruction to construct a simulator environment is received; and
   (e) constructing the simulator environment in which the object is disposed in the virtual work space and displaying a simulator image representing an operation of the virtual robot disposed in the virtual work space on the display device using the read layout data and attribute data.

10. A simulation apparatus that executes processing by using simulation data, the simulation data including (i) an operation program configured with a plurality of commands for causing a robot to perform a target operation, (ii) layout data representing a position and a posture of a three-dimensional object including a virtual robot disposed in a virtual work space which is a virtual three-dimensional work space, (iii) attribute data representing an attribute of the object, and (iv) a snapshot which is a two-dimensional image representing a state of the virtual work space, the simulation apparatus comprising:

   a simulator section that uses the layout data and the attribute data to construct a simulator environment in which the object is disposed in the virtual work space, and operates the virtual robot disposed in the virtual work space in the simulator environment based on an operation instruction of a user and displays a simulator image representing an operation of the virtual robot disposed in the virtual work space on a display device;
   a snapshot output section that outputs the snapshot, which is the two-dimensional image obtained by imaging a state in which the object including the virtual robot is disposed in the virtual work space by a virtual camera; and
   a data storage section that stores the simulation data including the operation program representing the target operation of the virtual robot based on the operation instruction, the layout data, the attribute data, and the snapshot in a memory, wherein
   when a selection of the desired simulation data is received from the user, the simulator section reads the snapshot included in the selected simulation data from the memory, and displays the snapshot as a preview image on the display device in a mode in which the selected simulation data can be identified and
   when an instruction for constructing the simulator environment is received from the user, the simulator section reads the layout data and the attribute data included in the selected simulation data from the memory and constructs the simulator environment by using the read layout data and attribute data and displays the simulator image on the display device.

# FIG. 1

# FIG. 2

INFORMATION PROCESSING APPARATUS — 700

CPU — 750

SIMULATOR — 751

DATA STORAGE SECTION — 753

SNAPSHOT OUTPUT SECTION — 752

CONTROLLER — 500

INPUT DEVICE — 730

DISPLAY DEVICE — 740

IF — 720

MEMORY — 710

SIMULATION PROGRAM — SP

ROBOT MODEL DATA — RD

OBJECT MODEL DATA — OD

USER-DEFINED MODEL DATA — UD,SF

LAYOUT DATA — LD,SF

OPERATION PROGRAM — RP,SF

SNAPSHOT — SD,SF

# FIG. 3

START

S101

RECEIVE SELECTION OF SIMULATION
FILE GROUP

S103

IS VALID SIMULATION
FILE GROUP SELECTED?  NO

YES

S105

DISPLAY SNAPSHOT

S107

NO  IS RESTORATION INSTRUCTED?

YES

S109

RESTORE SIMULATOR ENVIRONMENT

END

## FIG. 4

SC1

| REFERENCE TO FOLDER | ☒ |
|---|---|

SELECT FOLDER TO BE TARGET OF RESTORATION

∨ ▯ EpsonRCData
   ∨ ▯ EpsonRC
      > ▯ API
      ∨ ▯ Backup
         > ▯ Auto
         > ▯ B_RC700A_R7AA033922_2024-11-19_080853
         > ▯ B_RC700A_R7AA033922_2024-11-19_081102
         > ▯ B_RC700A_R7AA033922_2024-11-19_081310
         > ▯ B_RC700A_R7AA080092_2024-09-03_100144

| OK | CANCEL |
|---|---|

BT1

BT2

EP 4 763 437 A1

# FIG. 5

SC2

| | SIMULATOR DATA RESTORATION | ☒ |
| --- | --- | --- |

FOLDER [ B_RC700A_R7AA033922_2024-11-19_081102 ] [SELECTION]

SIMULATOR

> 𝄃 mnp01
◇ SPlane_1
🗁 CAD_2
✔ ⬡ SBox_2 ////////
   ⬡ SBox_3
> ⬡ SBox_4

| PROPERTY | SET VALUE |
| --- | --- |
| Name | SBox_2 |
| ⌄ Type | Layout |
| OffsetPosition | |
| X(mm) | 280.502 |
| Y(mm) | 332.938 |
| Z(mm) | 255.918 |
| | |
| X(degree) | 18.413 |
| Y(degree) | 0 |
| Z(degree) | 0 |
| › Position | |
| ⌄ Half size | |
| X(mm) | 25.000 |
| Y(mm) | 25.000 |
| Z(mm) | 25.000 |
| › Rotation | |
| Color | 128,255,128 |

[OK] [CANCEL]

F3 F1 BT3 F2

F4 BT4 BT5

# FIG. 6

IM_S    SC2

MODE [ SIMULATION ]

| > | mnp01 |
| | SPlane_1 |
| | CAD_2 |
| ✓ | SBox_2 |
| | SBox_3 |
| > | SBox_4 |

| PROPERTY | SET VALUE |
| --- | --- |
| Name | SBox_2 |
| Type | Layout |
| OffsetPosition | |
| X(mm) | 280.502 |
| Y(mm) | 332.938 |
| Z(mm) | 255.918 |
| | |
| X(degree) | 18.413 |
| Y(degree) | 0 |
| Z(degree) | 0 |
| Position | |
| Half size | |
| X(mm) | 25.000 |
| Y(mm) | 25.000 |
| Z(mm) | 25.000 |
| Rotation | |
| Color | 128,255,128 |

EP 4 763 437 A1

# FIG. 7

```
           START

           │
           ▼                    S210
┌─────────────────────────────┐
│      STORE LAYOUT DATA       │
└─────────────────────────────┘
           │
           ▼                    S230
┌─────────────────────────────┐
│   STORE OPERATION PROGRAM    │
└─────────────────────────────┘
           │
           ▼                    S250
┌─┬─────────────────────────┬─┐
│ │    GENERATE SNAPSHOT     │ │
└─┴─────────────────────────┴─┘
           │
           ▼                    S270
┌─────────────────────────────┐
│        STORE SNAPSHOT        │
└─────────────────────────────┘
           │
           ▼

            END
```

# FIG. 8

```
        ┌─────────────────┐
        │      START      │
        └─────────────────┘
                 │
                 ▼                        S251
        ┌─────────────────────────────┐
        │   DISPOSE VIRTUAL CAMERA     │
        │  TOWARD CENTER OF GRAVITY    │
        └─────────────────────────────┘
                 │
                 ▼◄──────────────────────────┐
                                             │
                 ▼                        S253 │
        ┌─────────────────────────────┐      │
        │  ADJUST POSITION AND POSTURE │      │
        │      OF VIRTUAL CAMERA       │      │
        └─────────────────────────────┘      │
                 │                            │
                 ▼           S255             │
              ╱───────────────╲       NO      │
             ╱  IS PHOTOGRAPHING ╲────────────┘
             ╲    POSSIBLE?     ╱
              ╲───────────────╱
                 │ YES
                 ▼                        S257
        ┌─────────────────────────────┐
        │      GENERATE SNAPSHOT        │
        └─────────────────────────────┘
                 │
                 ▼
        ┌─────────────────┐
        │     RETURN      │
        └─────────────────┘
```

20

# FIG. 9

START

DISPOSE VIRTUAL CAMERA TOWARD CENTER OF GRAVITY ⌐S251

ADJUST POSITION AND POSTURE OF VIRTUAL CAMERA ⌐S253

IS PHOTOGRAPHING POSSIBLE? ⌐S255b

NO

YES

PERFORM IMAGING ⌐S257b

CALCULATE NUMBER OF OBJECTS IN IMAGE AND RATIO OF AREA OCCUPIED BY OBJECT IN IMAGE ⌐S259

EXECUTE OPTIMIZATION PROCESSING ⌐S261

IS END CONDITION SATISFIED? ⌐S263

NO

YES

SELECT ONE SOLUTION FROM PARETO SOLUTIONS ⌐S265

OUTPUT SNAPSHOT BASED ON ONE SOLUTION ⌐S267

RETURN

21

# FIG. 10

SC4

SELECTION OF OPTIMAL SOLUTION ☒

SOLUTION OBTAINED BY OPTIMIZATION PROCESSING IS AS FOLLOWS. HATCHED CIRCLES REPRESENT PARETO SOLUTIONS.

SELECT ONE FROM PARETO SOLUTIONS.

- ○ A
- ○ B
- ○ C
- ○ D

EP 4 763 437 A1

Europäisches
Patentamt
European
Patent Office
Office européen
des brevets

# EUROPEAN SEARCH REPORT

**Application Number**

EP 25 22 0786

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/013605 A1 (YASKAWA DENKI SEISAKUSHO KK [JP]; SUYAMA TAKASHI [JP] ET AL.) 23 January 2014 (2014-01-23) * paragraph [0011] - paragraph [0063] * * figures 3-4 * | 1-10 | INV. B25J9/16 |
| A | WO 2024/075200 A1 (FANUC CORP [JP]) 11 April 2024 (2024-04-11) * the whole document * | 1-10 | |
| A | US 11 790 042 B1 (BAI YUNFEI [US]) 17 October 2023 (2023-10-17) * the whole document * | 1-10 | |

|  | TECHNICAL FIELDS SEARCHED (IPC) |
|---|---|
|  | B25J G05B |

The present search report has been drawn up for all claims

| Place of search | Date of completion of the search | Examiner |
|---|---|---|
| The Hague | 21 April 2026 | De Santis, Agostino |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 22 0786

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2026

| Patent document cited in search report | | Publication date | Patent family member(s) | | Publication date |
|---|---|---|---|---|---|
| WO 2014013605 | A1 | 23-01-2014 | CN | 104470687 A | 25-03-2015 |
| | | | EP | 2875914 A1 | 27-05-2015 |
| | | | JP | WO2014013605 A1 | 30-06-2016 |
| | | | US | 2015151431 A1 | 04-06-2015 |
| | | | WO | 2014013605 A1 | 23-01-2014 |
| WO 2024075200 | A1 | 11-04-2024 | CN | 119947863 A | 06-05-2025 |
| | | | DE | 112022007576 T5 | 28-05-2025 |
| | | | JP | WO2024075200 A1 | 11-04-2024 |
| | | | TW | 202415508 A | 16-04-2024 |
| | | | US | 20260086509 A1 | 26-03-2026 |
| | | | WO | 2024075200 A1 | 11-04-2024 |
| US 11790042 | B1 | 17-10-2023 | US | 11461589 B1 | 04-10-2022 |
| | | | US | 11790042 B1 | 17-10-2023 |
| | | | US | 12079308 B1 | 03-09-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024224108 A

- JP 2021045797 A